# FASCICULE DE BREVET EUROPEEN

(11) **EP 0 963 608 B1**
(45) Date de publication et mention de la délivrance du brevet: **02.08.2006**
(21) Numéro de dépôt: 98964544.5
(22) Date de dépôt: 29.12.1998
(51) Int. Cl.: H01L 27/02, H02H 9/04

(54) **CIRCUIT DE PROTECTION D'INTERFACE D'ABONNES**
SCHALTUNGSANORDNUNG ZUM SCHUTZ VON TEILNEHMERSCHNITTSTELLEN
SUBSCRIBER INTERFACE PROTECTION CIRCUIT

(30) Priorité: 30.12.1997 FR 9716854
(43) Date de publication de la demande: 15.12.1999
(73) Titulaire: STMicroelectronics S.A., 92120 Montrouge (FR)
(72) Inventeur: BALLON, Christian, F-37000 Tours (FR)
(74) Mandataire: de Beaumont, Michel
(86) Numéro de dépôt international: PCT/FR1998/002907
(87) Numéro de publication internationale: WO 1999/035692

(56) Documents cités:
- EP-A- 0 388 022
- EP-A- 0 550 198
- EP-A- 0 721 218

## Description

La présente invention concerne des circuits de protection contre des surtensions utilisables notamment pour des circuits d'interface de lignes d'abonnées, couramment désignés par le sigle SLIC (Subscriber Line Interface Circuit).

Les circuits téléphoniques reliés à des lignes sont particulièrement susceptibles d'être perturbés par des surtensions tels que des coups de foudre ou des liaisons accidentelles à des lignes du réseau d'alimentation électrique. De plus, le problème de la protection des circuits d'interface devient de plus en plus aigu alors que ces circuits d'interface sont constitués de circuits de plus en plus intégrés et de dimensions de plus en plus réduites et par conséquent de plus en plus sensibles à des surtensions.

La demanderesse étudie depuis de nombreuses années des circuits de protection de SLIC et a déjà imaginé plusieurs circuits nouveaux, réalisables sous forme monolithique, qui sont décrits notamment dans les brevets des Etats-Unis d'Amérique N° 5274524 (B1712), 5243488 (B1713), 5696391 (B2420) et 5684322 (B2743), et dans les demandes de brevets européens 0742592 (B2782) et 0687051 (B3042).

La présente invention vise à réaliser sous forme monolithique un circuit de protection susceptible d'établir un court-circuit entre chaque conducteur d'une ligne et la masse quand la tension sur ce conducteur dépasse un seuil positif déterminé ou devient inférieure à un seuil négatif prédéterminé.

La présente invention vise également à réaliser un tel circuit qui établit également un court-circuit entre un conducteur de ligne et la masse quand le courant dans ce conducteur dépasse un seuil déterminé.

La présente invention vise à réaliser un tel circuit qui puisse être fabriqué par des technologies compatibles avec celle des circuits intégrés de puissance développés par la demanderesse.

Un autre objet de la présente invention est de prévoir un tel circuit qui soit particulièrement fiable en fonctionnement.

Un autre objet de la présente invention est de prévoir un tel circuit dans lequel la chute de tension à l'état passant soit minimale (égale seulement à la chute de tension aux bornes d'un thyristor).

Un autre objet de la présente invention est de prévoir un tel circuit qui nécessite un très faible courant pour son amorçage.

Pour atteindre ces objets, la présente invention prévoit un composant monolithique de protection d'une ligne contre des surtensions supérieures à un seuil positif déterminé ou inférieures à un seuil négatif déterminé, comprenant en antiparallèle un thyristor à gâchette de cathode et un thyristor à gâchette d'anode connectés entre une première borne de la ligne à protéger et une tension de référence, la gâchette du thyristor à gâchette de cathode étant reliée à une tension de seuil négative par l'intermédiaire d'un transistor d'amplification de courant de gâchette, la gâchette du thyristor à gâchette d'anode étant reliée à une tension de seuil positive. Le composant monolithique est réalisé dans un substrat du premier type de conductivité divisé en caissons séparés par des murs d'isolement dont les faces inférieures sont revêtues de couches isolantes, la face inférieure du substrat étant uniformément revêtue d'une métallisation. Le transistor d'amplification du courant de gâchette du thyristor à gâchette de cathode est réalisé sous forme verticale dans un premier caisson. Le thyristor à gâchette de cathode est réalisé sous forme verticale dans un deuxième caisson. Le thyristor à gâchette d'anode est réalisé sous forme verticale dans un troisième caisson. La métallisation de face inférieure met en contact le collecteur du transistor, l'anode du thyristor à gâchette de cathode et la cathode du thyristor à gâchette d'anode. Une première métallisation de face avant relie la cathode du thyristor à gâchette de cathode à l'anode du thyristor à gâchette d'anode. Une deuxième métallisation de face avant relie la gâchette du thyristor à gâchette de cathode à l'émetteur du transistor. Une troisième métallisation de face avant est en contact avec la gâchette du thyristor à gâchette d'anode.

Selon un mode de réalisation de la présente invention, le composant comprend en outre une diode dont l'anode est reliée à la gâchette du thyristor à gâchette d'anode. Cette diode est réalisée sous forme d'une région de type P elle-même formée dans une région de type N, cette dernière étant formée dans la région de gâchette de cathode du thyristor à gâchette d'anode, du côté de la face supérieure du composant.

Selon un mode de réalisation de la présente invention, la gâchette du thyristor à gâchette de cathode est reliée à une deuxième borne de la ligne à protéger.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A représente un exemple de circuit de protection ;
la figure 1B représente un mode de réalisation selon la présente invention du circuit de la figure 1A ;
la figure 2A représente une variante de circuit de protection ;
la figure 2B représente un mode de réalisation selon la présente invention du circuit de la figure 2A ;
la figure 3A représente une autre variante de circuit de protection ;
la figure 3B représente un premier mode de réalisation selon la présente invention du circuit de la figure 3A ;
la figure 4A représente une autre variante de circuit de protection ; et
la figure 4B représente un premier mode de réalisation selon la présente invention du circuit de la figure 4A.

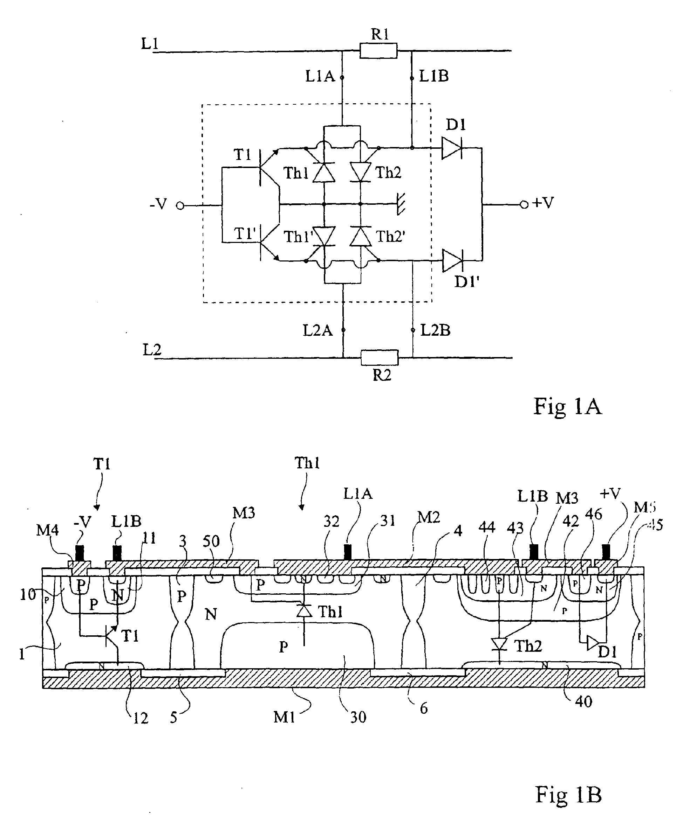

La figure 1A représente un circuit de protection contre des surtensions et des surintensités sur une ligne téléphonique L1-L2. Chacun des conducteurs de la ligne téléphonique comprend une résistance série, respectivement R1, R2, permettant de détecter des surintensités. On appellera L1A et L1B les bornes de la résistance R1 qui constituent des premières bornes d'entrée du circuit selon la présente invention et L2A et L2B les bornes de la résistance R2 qui constituent des deuxièmes bornes d'entrée du circuit. Entre la borne L1A et un potentiel de référence, couramment la masse, sont disposés deux thyristors en antiparallèle, à savoir un thyristor à gâchette de cathode Th1 et un thyristor à gâchette d'anode Th2. L'anode du thyristor Th1 et la cathode du thyristor Th2 sont reliées à la masse, la cathode du thyristor Th1 et l'anode du thyristor Th2 sont reliées à la borne L1A. La gâchette du thyristor à gâchette de cathode est reliée à une source de tension négative -V par l'intermédiaire d'un transistor amplificateur T1 de type NPN. La gâchette du thyristor à gâchette d'anode est reliée à une source de tension positive +V (dans ce mode de réalisation par l'intermédiaire d'une diode D1). Les gâchettes des thyristors Th1 et Th2 sont reliées à la borne L1B. L'émetteur du transistor T1 est relié à la borne L1B, son collecteur à la masse et sa base à la tension négative -V. Cet ensemble constitue le système de protection contre des surtensions et surintensités du conducteur L1. Des composants disposés symétriquement et désignés par des références primées constituent la protection contre des surtensions et des surintensités de la ligne L2. Le fonctionnement de ce circuit que l'on comprendra mieux en se référant aux brevets et demandes de brevets de la demanderesse mentionnés ci-dessus est le suivant.
- Si une surtension positive supérieure à la tension +V survient sur le conducteur L1, un courant circule de l'anode à la gâchette du thyristor à gâchette d'anode Th2 par l'intermédiaire de la diode D1 vers la tension +V. Le thyristor Th2 devient passant et dérive la surtension vers la masse.
- Si une surtension négative inférieure à la tension -V survient sur le conducteur L1, le thyristor à gâchette de cathode Th1 devient conducteur et la surtension négative s'écoule vers la masse. Le transistor T1 augmente la sensibilité de déclenchement en jouant un rôle d'amplification de gâchette.
- Si un courant positif circule dans la résistance R1 de façon à produire aux bornes de cette résistance une tension supérieure à la tension de seuil du thyristor à gâchette d'anode Th2, celui-ci devient passant.
- Si un courant négatif circule dans la résistance R1, c'est le thyristor à gâchette de cathode Th1 qui devient passant.

On a donc ainsi obtenu effectivement un dispositif de protection contre des surtensions et des surintensités sur le conducteur L1. La partie inférieure du circuit joue le même rôle vis-à-vis du conducteur L2.

On notera que les valeurs des tensions +V et -V, qui seront par exemple fournies par des batteries, ne sont pas nécessairement égales.

Le rôle des diodes D1 et D1' est d'isoler les batteries +V et -V entre elles, ainsi que par rapport aux lignes L1 et L2 en l'absence de surtensions.

La figure 1B est une vue en coupe schématique d'une tranche semiconductrice incorporant le circuit de la figure 1A. Seuls les éléments appartenant à la partie supérieure du circuit de protection de la figure 1A sont représentés en figure 1B. Les composants symétriques dans le circuit sont formés de la même façon dans la même tranche de silicium comme cela apparaîtra clairement à l'homme de l'art.

Le composant de la figure 1B est formé à partir d'un substrat 1 de type N divisé en trois caissons par des murs d'isolement 3 et 4. Chaque mur d'isolement est formé par une diffusion profonde de type P s'étendant à partir des faces supérieure et inférieure de la tranche, ces diffusions se rejoignant sensiblement au milieu de la tranche. Le composant est réalisé dans une technologie de composants semiconducteurs de puissance dans laquelle une métallisation unique M1 recouvre toute la face inférieure ou face arrière du composant. Selon un aspect de la présente invention, on utilise une technologie dans laquelle la partie apparente de chaque mur d'isolement du côté de la face inférieure est isolée par une couche d'isolement. La référence 5 désigne une couche d'isolement, couramment de l'oxyde de silicium, formée sous la face inférieure du mur d'isolement 3 et la référence 6 désigne une couche d'isolement formée sous la face inférieure du mur d'isolement 4.

Dans le caisson de gauche est formé le transistor T1. Ce transistor est de type vertical et comprend du côté de la face supérieure une région de base 10 de type P contenant une région d'émetteur 11 de type N. Du côté de la face inférieure est formée une région 12 de type N⁺ constituant le contact de collecteur repris par la métallisation M1. On notera que la couche isolante 5 se prolonge pour que la métallisation M1 fasse contact avec la région N 12 et pas avec le substrat 1 du caisson. Un avantage de la réalisation de ce transistor sous forme verticale est qu'il peut supporter sans difficultés des tensions relativement élevées (la tension -V est par exemple de -50 V). De plus la connexion entre le collecteur de ce transistor et l'anode du thyristor à gâchette de cathode Th1 est réalisée de façon particulièrement simple et efficace par la métallisation de face arrière. En outre le transistor T1 présente un gain élevé (de l'ordre de 80 à 200) ce qui entraîne que le courant que doit fournir la batterie -V à chaque amorçage est particulièrement faible.

Le thyristor à gâchette de cathode Th1 est formé dans le caisson central de la figure 1B. Il est réalisé sous forme verticale. Il comprend du côté de la face inférieure une région d'anode 30 et du côté de la face supérieure une région de type P 31 et une région de type N de cathode 32, couramment munie de courts-circuits d'émetteur. On notera que les régions isolantes 5 et 6 se prolongent jusqu'à la région P 30 pour que la métallisation M1 ne soit pas en contact avec le caisson central de type N.

Dans le caisson de droite de la figure 1B sont formés le thyristor à gâchette d'anode Th2 et la diode D1. Le thyristor Th2 est réalisé comme le thyristor Th1 sous forme verticale. Il comprend du côté de la face inférieure une région N 40 de cathode, et du côté de la face supérieure une région de type P profonde et peu dopée 42 (réalisée en même temps que la région d'anode 30 du thyristor Th1) dans laquelle sont formées une région de type N 43 et une région d'anode de type P 44. De façon classique, la région d'anode est munie de courts-circuits d'émetteurs. La diode D1 est formée dans la région de type P 42 elle comprend dans cette région une région de type N 45 constituant sa cathode et une région de type P 46 constituant son anode. Il s'agit d'une diode latérale.

Du côté de la face supérieure, les contacts sont réalisés par diverses métallisations :
- une métallisation M2 connectée à la borne L1A reliant la cathode du thyristor à gâchette de cathode à l'anode du thyristor à gâchette d'anode,
- une métallisation M3 connectée à la borne L1B reliant la gâchette du thyristor à gâchette de cathode à l'émetteur du transistor T1 et la gâchette du thyristor à gâchette d'anode à l'anode de la diode D1 ; bien que dans la vue en coupe cette métallisation soit représentée comme constituée de deux morceaux disjoints, on comprendra qu'il s'agit d'une seule et même métallisation,
- une métallisation M4 reliée à la borne -V en contact avec la base du transistor T1, et
- une métallisation M5 reliée à la borne +V en contact avec la cathode de la diode D1.

Cette structure permet de commander le thyristor Th1 avec un très faible courant de mise en conduction tandis que ce thyristor peut avoir un courant de maintien (Ih) élevé. La réalisation du thyristor Th2 par triple diffusion permet d'obtenir un thyristor sensible.

On a en outre représenté sur la figure des régions plus fortement dopées de même type que les régions sous-jacentes pour améliorer l'ohmicité des contacts avec les diverses métallisations. Ces régions ne sont ni référencées ni décrites pour ne pas alourdir les figures et la description. Également, des régions telle que la région 50 constituent de façon classique des régions d'arrêt de canal pour éviter l'apparition de courants de fuite.

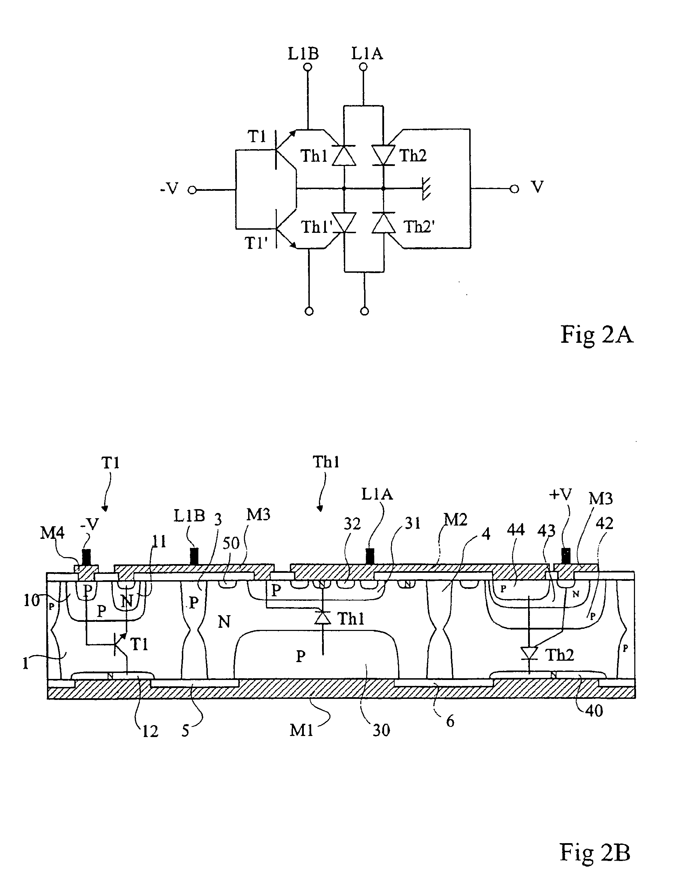

La figure 2A représente une variante du circuit de la figure 1A. On y retrouve les éléments T1, Th1, Th2, T'1, Th'1, Th'2. La différence avec la figure 1A est que la gâchette du thyristor à gâchette d'anode Th2 n'est pas reliée à la gâchette du thyristor à gâchette de cathode Th1 et est reliée directement, ainsi que la gâchette du thyristor à gâchette d'anode Th'2 à la tension de référence positive +V. Ce circuit est plus simple mais n'assure pas de protection contre des surintensités positives. Il présente toutefois l'avantage que le thyristor à gâchette d'anode est particulièrement sensible en raison de l'absence de courts-circuits d'anode.

La réalisation de ce circuit sous forme d'un composant monolithique apparaît en figure 2B. Cette figure ne sera pas décrite en détail puisqu'elle est strictement similaire à la figure 1B sans la diode D1, c'est-à-dire que la région de gâchette d'anode 43 du thyristor à gâchette d'anode Th2 est connectée directement à la tension positive +V. On notera également que la couche d'anode 44 du thyristor à gâchette d'anode n'est pas dans le mode de réalisation de la figure 2B muni de courts-circuits d'émetteur, ce qui permet d'obtenir un thyristor plus sensible.

D'autre part, dans le cas des figures 1B et 2B, on a représenté la couche d'isolement 6 s'étendant jusqu'à la région 40 de prise de contact de cathode du thyristor à gâchette d'anode Th2. Bien entendu, comme cette couche de contact est du même type que le substrat, la couche isolante 6 peut s'arrêter immédiatement au-delà de la surface inférieure du mur d'isolement 4.

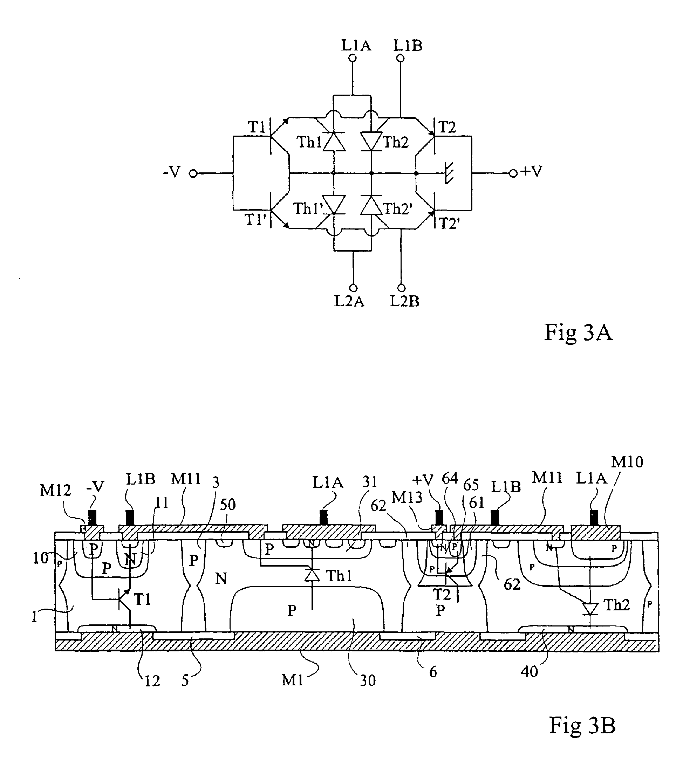

La figure 3A représente une autre variante du circuit selon la présente invention. Cette fois-ci, la structure est complètement symétrique, c'est-à-dire que le thyristor à gâchette d'anode Th2 est, comme le thyristor à gâchette de cathode Th1 associé à un transistor d'amplification de courant de gâchette. Ce transistor est désigné par la référence T2 pour le thyristor Th2 et par la référence T2' pour le thyristor Th2'. Les transistors T2 et T2' sont des transistors PNP alors que les transistors T1 et T'1 sont des transistors NPN.

Une réalisation selon la présente invention sous forme monolithique du circuit de la figure 3A apparaît en une coupe schématique en figure 3B. Le transistor T1 et le thyristor Th1 sont réalisés comme dans les modes de réalisation des figures 1B et 2B. Le thyristor Th2 est réalisé comme celui de la figure 1B ou de la figure 2B selon la sensibilité recherchée pour ce thyristor. Le transistor T2 est réalisé entre les caissons contenant les thyristors Th1 et Th2. Le collecteur de ce thyristor est constitué d'une couche de type P 61 profondément diffusée à partir de la face supérieure. La région 61 est entourée d'une diffusion profonde de type P 62 qui rejoint une couche de type 63 formée à partir de la face inférieure et sur laquelle est reprise le contact de collecteur par la métallisation M1. A l'intérieur de la région de collecteur 61 sont formées une région de base 64 et une région d'émetteur de type P 65.

Une première métallisation de face supérieure M10 connectée à la borne L1A est en contact avec la cathode du thyristor Th1 et l'anode du thyristor Th2 (bien que cette métallisation soit représentée en deux morceaux dans la figure, il s'agit d'une seule et même métallisation). Une métallisation M11 connectée à la borne L1B est en contact avec la gâchette du thyristor Th2, l'émetteur du transistor T2, la gâchette du thyristor Th1 et l'émetteur du transistor T1. Une métallisation M12 connectée à la borne -V est en contact avec la base du transistor T1. Une métallisation M13 connectée à la borne +V et est en contact avec la région de base du transistor T2.

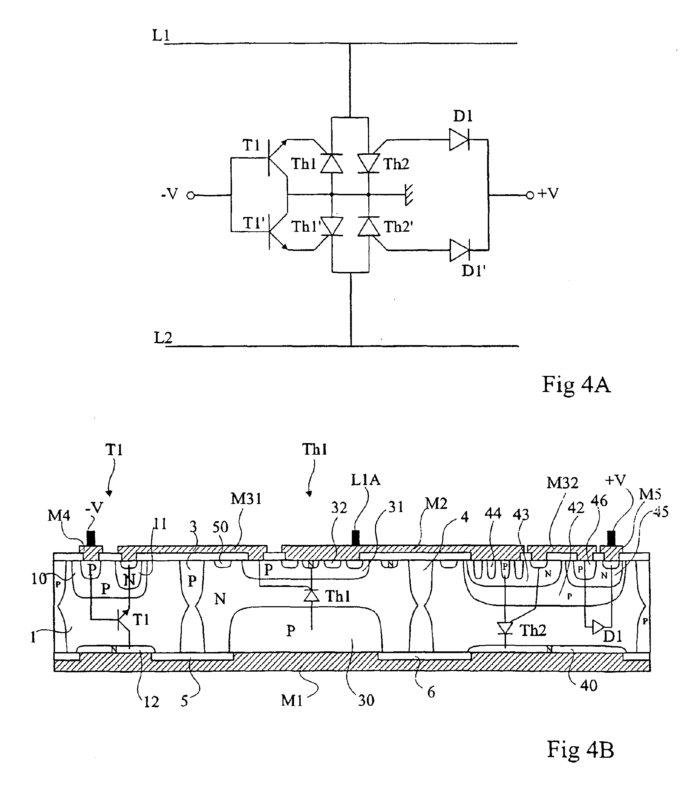

La figure 4A représente une variante du circuit de la figure 1A. Ce circuit, plus simple, n'assure pas de protection contre des surintensités. On y retrouve les éléments T1, Th1, Th2, T'1, Th'1, Th'2. La différence avec la figure 1A est que les gâchettes des thyristors à gâchette d'anode Th2 et à gâchette de cathode Th1 ne sont reliées ni entre elles ni à la borne L1B qui n'existe pas, la résistance R1 étant absente.

La réalisation de ce circuit sous forme d'un composant monolithique apparaît en figure 4B. Cette figure ne sera pas décrite en détail puisqu'elle est identique à la figure 1B à l'exception de la métallisation de gâchette : au lieu d'avoir une métallisation M3 unique, on a deux métallisations disjointes M31 et M32 servant seulement, respectivement à établir la liaison avec l'émetteur du transistor T1 et la liaison avec l'anode de la diode D1 (on pourra éventuellement supprimer la diode D1).

Bien entendu, la présente invention est susceptible de diverses variantes et modifications qui apparaîtront à l'homme de l'art. En particulier, les diverses variantes décrites pourront être combinées.

## Revendications

1. Composant monolithique de protection d'une ligne contre des surtensions supérieures à un seuil positif déterminé ou inférieures à un seuil négatif déterminé, comprenant en antiparallèle un thyristor à gâchette de cathode (Th1) et un thyristor à gâchette d'anode (Th2) connectés entre une première borne (L1A) de la ligne à protéger et une tension de référence, la gâchette du thyristor à gâchette de cathode étant reliée à une tension de seuil négative (-V) par l'intermédiaire d'un transistor d'amplification de courant de gâchette (T1), la gâchette du thyristor à gâchette d'anode étant reliée à une tension de seuil positive (+V), où :
- le composant monolithique est réalisé dans un substrat du premier type de conductivité divisé en caissons séparés par des murs d'isolement (3, 4) dont les faces inférieures sont revêtues de couches isolantes (5, 6), la face inférieure du substrat étant uniformément revêtue d'une métallisation (M1),
- le transistor (T1) d'amplification du courant de gâchette du thyristor à gâchette de cathode est réalisé sous forme verticale dans un premier caisson,
- le thyristor à gâchette de cathode (Th1) est réalisé sous forme verticale dans un deuxième caisson,
- le thyristor à gâchette d'anode (Th2) est réalisé sous forme verticale dans un troisième caisson,
- la métallisation de face inférieure (M1) met en contact le collecteur du transistor, l'anode du thyristor à gâchette de cathode et la cathode du thyristor à gâchette d'anode,
- une première métallisation de face avant (M2) relie la cathode du thyristor à gâchette de cathode à l'anode du thyristor à gâchette d'anode,
- une deuxième métallisation de face avant (M3) relie la gâchette du thyristor à gâchette de cathode à l'émetteur du transistor, et
- une troisième métallisation de face avant est en contact avec la gâchette du thyristor à gâchette d'anode.

2. Composant selon la revendication 1, comprenant en outre une diode (D1) dont l'anode est reliée à la gâchette du thyristor à gâchette d'anode, **caractérisé en ce que** ladite diode est réalisée sous forme d'une région de type P (46), elle-même formée dans une région de type N (45), cette dernière étant formée dans la région de gâchette de cathode (42) du thyristor à gâchette d'anode, du côté de la face supérieure du composant.

3. Composant selon la revendication 1, dans lequel la gâchette du thyristor à gâchette de cathode est reliée à une deuxième borne de la ligne à protéger (L1B)

4. Composant selon la revendication 1 ou 2, assurant en outre une fonction de protection contre des surintensités, dans lequel les gâchettes des thyristors à gâchette de cathode et à gâchette d'anode sont reliées entre elles et à une deuxième borne de la ligne à protéger (L1B)

5. Composant selon la revendication 4 prise dans son rattachement à la revendication 1, comprenant en outre un transistor d'amplification de courant de gâchette (T2) associé au thyristor à gâchette d'anode, **caractérisé en ce que** ce transistor, de type PNP, est formé du côté de la face supérieure du composant, la région de collecteur (61) se prolongeant par l'intermédiaire de murs d'isolement (62, 63) vers la face inférieure et étant en contact avec la métallisation de face inférieure (M1).

## Claims

1. A monolithic component protecting a line against overvoltages greater than a determined positive threshold or smaller than a determined negative threshold, including in antiparallel a cathode-gate thyristor (Th1) and an anode-gate thyristor (Th2) connected between a first terminal (L1A) of the line to be protected and a reference voltage, the gate of the cathode-gate thyristor being connected to a negative threshold voltage (-V) via a gate current amplification transistor (T1), the gate of the anode-gate thyristor being connected to a positive threshold voltage (+V), wherein:
- the monolithic component is made in a substrate of the first conductivity type divided into wells separated by isolating walls (3, 4), the smaller surfaces of which are coated with insulating layers (5, 6), the smaller surface of the substrate being uniformly coated with a metallization (M1),
- the gate current amplification transistor (T1) of the cathode-gate thyristor is made in vertical form in a first well,
- the cathode-gate thyristor (Th1) is implemented in vertical form in a second well,
- the anode-gate thyristor (Th2) is implemented in vertical form in a third well,
- the smaller surface metallization (M1) links up the collector of the transistor, the anode of the cathode-gate thyristor, and the cathode of the anode-gate thyristor,
- a first front surface metallization (M2) connects the cathode of the cathode-gate thyristor to the anode of the anode-gate thyristor,
- a second front surface metallization (M3) connects the gate of the cathode-gate thyristor to the emitter of the transistor, and
- a third front surface metallization is in contact with the gate of the anode-gate thyristor.

2. The component of claim 1, further including a diode (D1), the anode of which is connected to the gate of the anode-gate thyristor, **characterized in that** the diode is implemented in the form of a P-type region (46) itself formed in an N-type region (45), the latter being formed in the cathode-gate region (42) of the anode-gate thyristor, on the upper surface side of the component.

3. The component of claim 1, wherein the gate of the cathode-gate thyristor is connected to a second terminal of the line to be protected (L1B).

4. The component of claim 1 or 2, further ensuring a protective function against overcurrents, in which the gates of the cathode-gate and anode-gate thyristors are interconnected and connected to a second terminal of the line to be protected (L1B).

5. The component of claim 4 taken as attached to claim 1, further including a gate current amplification transistor (T2) associated with the anode-gate thyristor, **characterized in that** this transistor, of PNP type, is formed on the upper surface of the component, the collector region (61) extending via isolating walls (62, 63) towards the smaller surface and being in contact with the smaller surface metallization (M1).

## Patentansprüche

1. Eine monolithische Komponente, die eine Leitung gegenüber Überspannungen schützt, die größer sind als eine bestimmte positive Schwelle oder kleiner als eine bestimmte negative Schwelle, wobei die Komponente Folgendes aufweist: einen Kathoden-Gate-Thyristor (Th1) und antiparallel geschaltet einen Anoden-Gate-Thyristor (Th2) und zwar verbunden zwischen einem ersten Anschluss (L1A) der zu schützenden Leitung und einer Bezugsspannung, wobei das Gate des Kathoden-Gate-Thyristors (Th1) mit einer negativen Schwellenspannung (-V) verbunden ist, und zwar über einen Gate-Stromverstärkungstransistor (T1), wobei das Gate des Anoden-Gate-Thyristors mit einer positiven Schwellenspannung (+V) verbunden ist, und wobei Folgendes gilt:
- die monolithische Komponente ist in einem Substrat des ersten Leitfähgikeitstyps hergestellt und zwar unterteilt in zwei Wannen getrennt durch Isolierwände (3, 4), wobei die kleineren Oberflächen derselben mit Isolierschichten (5, 6) beschichtet sind, wobei die kleinere Oberfläche des Substrats gleichförmig mit einer Metallisierung (M1) beschichtet ist.
- der Gatestromverstärkungstransistor (T1) des Kathoden-Gate-Thyristors ist in einer ersten Wanne in Vertikalform hergestellt,
- der Kathoden-Gate-Thyristor (Th1) ist in der zweiten Wanne in Vertikalform implementiert,
- der Anoden-Gate-Thyristor (Th2) ist in Vertikalform in einer dritten Wanne implementiert,
- die eine kleinere Oberfläche aufweisende Metallisierung (M1) verbindet den Koliektor des Transistors, die Anode des Kathoden-Gate-Thyristors und die Kathode des Anoden-Gate-Thyristors,
- eine erste Vorderseitenoberflächenmetallisierung (M2) verbindet die Kathode des Kathoden-Gate-Thyristors mit der Anode des Anoden-Gate-Thyristors,
- eine zweite Vorderoberflächemetallisierung (M3) verbindet das Gate des Kathoden-Gate-Thyristors mit dem Emitter des Transistors, und
- eine dritte Vorderoberflächenmetallisierung steht in Kontakt mit dem Gate des Anoden-Gate-Thyristors.

2. Komponente nach Anspruch 1, wobei ferner Folgendes vorgesehen ist: eine Diode (D1), deren Anode mit dem Gate des Anoden-Gate-Thyristors verbunden ist, **dadurch gekennzeichnet**, dsiss die Diode in der Form einer p-Typ-Zone (46) implementiert ist, die selbst in einer n-Typ-Zone (45) gebildet ist, wobei letztere in der Kathoden-Gate-Zone (42) des Anoden-Gate-Thyristors gebildet ist, und zwar auf der oberen Oberfläche bzw. Oberseite der Komponente

3. Komponente nach Anspruch 1, wobei das Gate des Kathoden-Gate-Thyristors mit einem zweiten Anschluss der zu schützenden Leitung (L1B) verbunden ist.

4. Komponente nach Anspruch 1 oder 2, wobei ferner zur weiteren Sicherstellung einer Schutzfunktion gegenüber überströmen, die Gates der Kathoden-Gate- und Anoden-Gate-Thyristoren miteinander verbunden sind, und ferner verbunden sind mit einem zweiten Anschluss der zu schützenden Leitung (L1B).

5. Komponente nach Anspruch 4 bei Abhängigkeit von Anspruch 1, wobei ferner ein Gate-Strom-Verstärkungstransistor (T2) mit dem Anoden-Gate-Thyristor assoziiert ist, **dadurch gekennzeichnet, dass** dieser Transistor des pnp-Typs auf der oberen Oberfläche (Oberseite der Komponente) geformt ist, wobei sich die Kollektorzone (61) über Isolierwände (62, 63) zu der kleineren Oberfläche erstreckt und in Kontakt steht mit der eine kleinere Oberfläche aufweisenden Metallisierung (M1).
